Europäisches Patentamt

European Patent Office

Office européen des brevets

(19)

(11) Veröffentlichungsnummer: **0 019 779 B1**

(12) **EUROPÄISCHE PATENTSCHRIFT**

(45) Veröffentlichungstag der Patentschrift:
12.10.83

(51) Int. Cl.³: **G 03 F 1/00**

(21) Anmeldenummer: 80102567.7

(22) Anmeldetag: 09.05.80

(54) Schattenwurfmaske zum Strukturieren von Oberflächenbereichen und Verfahren zu ihrer Herstellung.

(30) Priorität: 01.06.79 DE 2922416

(43) Veröffentlichungstag der Anmeldung:
10.12.80 Patentblatt 80/25

(45) Bekanntmachung des Hinweises auf die Patenterteilung:
12.10.83 Patentblatt 83/41

(84) Benannte Vertragsstaaten:
DE FR GB

(56) Entgegenhaltungen:
EP-A-0 001 038
DE-A-1 289 714
US-A-3 742 230

(73) Patentinhaber: International Business Machines
Corporation, Old Orchard Road, Armonk, N.Y. 10504 (US)

(72) Erfinder: Bohlen, Harald, Geleener Strasse 26,
D-7030 Böblingen (DE)
Erfinder: Engelke, Helmut, Dr., Ahornweg 33,
D-7031 Altdorf (DE)
Erfinder: Greschner, Johann, Dr., Zollernstrasse 14,
D-7401 Pliezhausen 2 (DE)
Erfinder: Nehmiz, Peter, Dr., Adlerstrasse 7,
D-7030 Böblingen (DE)

(74) Vertreter: Oechssler, Dietrich, Dr.rer.nat. Dipl.-Chem.,
Schönaicher Strasse 220, D-7030 Böblingen (DE)

## Schattenwurfmaske zum Strukturieren von Oberflächenbereichen und Verfahren zu ihrer Herstellung

Die Erfindung betrifft eine Maske, welche im Oberbegriff des Anspruchs 1 definiert ist und ein Verfahren zur Herstellung einer Maske, wie es im Oberbegriff des Anspruchs 1 definiert ist.

Eine Maske der genannten Art lässt sich beispielsweise beim Ionenätzen, bei der Ionenimplantation und bei der Röntgen-Ionen- und Elektronenstrahllithographie einsetzen. Im folgenden wird im wesentlichen nur auf die Verwendung der genannten Maske bei der Elektronenstrahllithographie Bezug genommen. Diese Beschränkung ist deshalb zweckmässig, da einerseits die genannte Maske sich bei der Elektronenstrahllithographie besonders vorteilhaft einsetzen lässt und anderseits die dabei zu beachtenden Faktoren und die zu überwindenden Schwierigkeiten für die anderen Einsatzmöglichkeiten der genannten Maske genauso typisch sind. Diese Beschränkung auf die Elektronenstrahllithographie bedeutet jedoch nicht, dass die genannte Maske nicht ebenso für die anderen genannten Zwecke eingesetzt werden kann.

Zur Herstellung von Strukturen mit Elementen, deren Abmessungen im µm-Bereich und darunter liegen, auf «photo»-lithographischem Weg, ist ultraviolettes Licht zur Bestrahlung nicht mehr geeignet, da sich mit ihm nicht die notwendige Auflösung erzielen lässt. In solchen Fällen wird der strahlungsempfindliche Lack bevorzugt mit Elektronen bestrahlt. Üblicherweise werden dabei sogenannte Elektronenstrahl-Muster-Erzeuger angewandt. In diesen Geräten wird das mit einem strahlungsempfindlichen Lack beschichtete Werkstück, beispielsweise ein Halbleiterplättchen direkt selektiv bestrahlt, indem man einen Elektronenstrahl, dessen Durchmesser kleiner ist als die Abmessung des kleinsten in der herzustellenden Struktur vorhandenen Strukturelements, in der Weise die Lackschicht überstreichen lässt, dass am Ende der Bestrahlung sich jeder Punkt der Lackschicht im Strahlengang befunden hat, wobei beim Überstreichen der Elektronenstrahl überall dort ausgeblendet wird, wo der Lack nicht bestrahlt werden soll. Mit diesen Geräten lassen sich sehr komplexe und kleinste Musterelemente aufweisende Muster mit ausreichender Genauigkeit übertragen. Nachteilig an diesen Geräten ist jedoch, dass sie apparativ sehr aufwendig sind und dass der erreichbare Durchsatz so gering ist, dass sie in einer fabrikmässigen Fertigung praktisch nicht eingesetzt werden können.

Ein grösserer Durchsatz lässt sich erzielen, wenn die Lackschicht auf dem Werkstück durch eine Maske hindurch bestrahlt wird, welche von der Lackschicht nur einen geringen Abstand hat ($\leq 500$ µm) und welche das zu übertragende Muster im Verhältnis 1:1 in geeigneter Weise enthält. Zur Übertragung des Musters geht man dabei so vor, dass zunächst die Maske zum Werkstück justiert wird und dann eine Elektronenstrahl, dessen Durchmesser unkritisch ist, Zeile für Zeile über die Maske geführt wird, bis schliesslich jeder Punkt der Marke bestrahlt worden ist. Die Maske kann dabei das gesamte zu übertragende Muster enthalten, in welchem Fall das bestrahlte Werkstück gleich zum nächsten Verfahrensschritt geleitet werden kann. Besteht das zu übertragende Muster, wie es in der Halbleitertechnik allgemein üblich ist, aus einer grossen Anzahl von identischen Teilmustern, dann kann auch eine Maske verwendet werden, in welcher nur ein solches Teilmuster enthalten ist, wobei dann beim Bestrahlen so vorgegangen wird, dass bei einem ersten Ausrichten von Maske zu Werkstück das Teilmuster übertragen wird, anschliessend die Maske gegenüber dem Werkstück um eine Strecke, welche mindestens der Breite oder der Länge des Teilmusters entspricht, verschoben wird, anschliessend das Teilmuster erneut übertragen wird und diese Verfahrensschritte so lange wiederholt werden, bis die gewünschte Anzahl von Teilmustern in die strahlungsempfindliche Schicht auf dem Werkstück übertragen ist.

Die Voraussetzung, um mit diesem Verfahren Muster mit der notwendigen Genauigkeit und dem erwünschten hohen Durchsatz zu übertragen, ist eine Maske, welche bestimmte Bedingungen erfüllen muss. Eine solche Maske muss an den Stellen, an welchen sie für Elektronen durchlässig sein soll, durchgehende Löcher aufweisen. An jeder noch so dünnen Materialschicht würden nämlich die Elektronen so stark gestreut werden, dass eine Musterübertragung mit einer exakten Kantendefinition im µm oder Sub-µm-Bereich unmöglich wäre. Das Lochmuster in der Maske muss das zu übertragende Muster mindestens mit derselben Genauigkeit wiedergeben, mit der das Muster übertragen werden soll. Die Bereiche der Maske, welche für die Übertragung des Musters verantwortlich sind, d.h. insbesondere die Bereiche in der Umgebung der Lochkanten müssen ausserdem die richtige Dicke aufweisen. Einerseits müssen diese Bereiche so dick sein, dass an den Stellen, an welchen keine Elektronen durchgelassen werden sollen, auch wirklich alle Elektronen absorbiert werden. Anderseits dürfen diese Bereiche zur Vermeidung von Streueffekten an den Kanten des Musters nicht zu dick sein. Diese Streueffekte verhindern eine exakte Definition des Musters beim Übertragen auf die strahlungsempfindliche Schicht. Schliesslich muss die Maske termisch stabil sein, da ein hoher Durchsatz nur mit einem entsprechend hohen Elektronenstrom, welcher notwendigerweise zur Erwärmung der Maske führt, erreicht werden kann.

Masken zur Verwendung in der Elektronenstrahllithographie mit durchgehenden Löchern sind bekannt. So hat beispielsweise L-N. Heynick in dem in den IEEE Transactions on Electron Devices, Bd. ED–22, Nr. 7, Juli 1975, Seiten 399 ff. veröffentlichten Artikel mit dem Titel «Projection Electron Lithography Using Aperture Lenses» eine Maske beschrieben, bei deren Herstellung von einem Siliciumplättchen, auf welche eine dünne Chromschicht und eine Goldschicht aufgebracht ist, ausgegangen wird. Das Maskenmuster wird in die beiden Metallschichten und ungefähr 25 bis 50 µm tief in das Siliciumsubstrat hineingeätzt. Anschliessend wird das Siliciumplättchen von der Rückseite her soweit gedünnt, dass die Maskenlöcher auch zur Rückseite hin geöffnet sind. Die fertige Maske erfüllt zwar die Bedingung, dass sie durchgehende Löcher aufweist, jedoch ist es mit dem angegebenen Verfahren unmöglich, reproduzierbar Masken zu erzeugen, welche die richtige Dicke aufweisen. In dem Artikel «Fabricating Shaped Grid and Aperture Holes» von R. A. Leone u. a., welcher im IBM Technical Disclosure Bulletin, Bd. 14, Nr. 2, Juli 1972, Seite 417 veröffentlicht ist, ist die Herstellung einer Maske mit durchgehenden Löchern aus einem Siliciumplättchen beschrieben. Dabei wird zunächst auf dem $N^+$-dotierten Siliciumsubstrat eine dünne N-dotierte Epitaxieschicht aufgewachsen. In der Epitaxieschicht wird dann das Maskenmuster erzeugt. Anschliessend wird das Substrat von der Plättchenrückseite her gedünnt, wobei ein Ätzmittel verwendet wird, welches $N^+$-dotiertes Silicium in Gegenwart von N-dotiertem Silicium selektiv ätzt. Auf diese Weise lässt sich die Dicke der stehenbleibenden Siliciumschicht – es handelt sich dabei im wesentlichen um die Epitaxieschicht – leicht und genau steuern. Um die Wärmeleitfähigkeit der Maske und um ihre Fähigkeit, Elektronen zu absorbieren, zu verbessern, wird ausserdem vorgeschlagen, die Epitaxieschicht mit einer dünnen Goldschicht zu bedecken. Eine weitere Maske mit durchgehenden Löchern und ihre Herstellung ist in der europäischen Patentanmeldung 0 001 038 beschrieben. Auch bei der Herstellung dieser Maske wird von einem Siliciumplättchen ausgegangen. Um nach dem Ätzen des Maskenmusters in das Siliciumplättchen dieses von der Rückseite her definiert dünn ätzen zu können, wird zu Beginn der Herstellung auf der Plättchenvorderseite eine hoch mit Bor dotierte Oberflächenschicht festgelegter Dicke im schwach P-dotierten Substrat erzeugt, welche von dem Ätzmittel, welches beim Dünnätzen verwendet wird, praktisch nicht angegriffen wird. Die beiden zuletzt besprochenen Masken haben den Nachteil, dass, wenn mit ihnen Musterelemente mit Abmessungen im µm-Bereich oder darunter übertragen werden sollen, bei den heutigen Anforderungen an die Masken das Muster verfälschende Streueffekte zu befürchten sind. Wenn nämlich der dünngeätzte Bereich, in dem das Maskenmuster ausgebildet ist, eine relativ grosse Spannweite haben soll, so darf seine Dicke aus Gründen der notwendigen thermischen und mechanischen Stabilität einen bestimmten Wert nicht unterschreiten. So kann die Dicke des dünngeätzten Bereichs nicht unter einen Wert von wenigen µm reduziert werden, wenn sich diese Bereiche der Maske, wie es für die Bestrahlung von heute in der Halbleitertechnik üblichen Chips wünschenswert ist, ohne Unterstützung über eine Strecke von mehreren Millimeter erstrecken soll. Je dicker jedoch die Maske im Bereich der das Muster definierenden Lochkanten ist, desto eher treten die Streueffekte auf.

Es ist die Aufgabe der Erfindung, eine Maske für das Strukturieren von Oberflächenbereichen, welche in der Lage ist, Strukturelemente, deren kleinste Abmessungen im µm-Bereich und darunter liegen, mit sehr grosser Mustergenauigkeit zu übertragen, wobei mit hohem Durchsatz gearbeitet werden kann, und ein rationelles und relativ einfaches Verfahren insbesondere zur Herstellung einer solchen Maske anzugeben.

Diese Aufgabe wird mit einer Maske nach Anspruch 1 und mit einem Verfahren nach Anspruch 11 gelöst.

Die erfindungsgemässe Maske ist mechanisch – sogar bei thermischer Belastung – auch dann stabil, wenn die wannenförmigen Vertiefungen relativ gross sind und infolgedessen der nur wenige µm dicke Bereich der Maske eine relativ grosse Spannweite hat. Dies ist deshalb der Fall, weil die aus der anders dotierten Schicht bestehende Struktur relativ dick sein kann. Denn auch dann, wenn die dotierte Schicht relativ dick ist, ist bei der erfindungsgemässen Maske keine durch Streueffekte verursachte Beeinträchtigung der Genauigkeit zu befürchten, mit welcher die Muster übertragen werden. Dies trifft auch dann zu, wenn das zu übertragende Muster Elemente mit Abmessungen im Submikrometer-Bereich aufweist. Dadurch unterscheidet sich die erfindungsgemässe Maske von den bekannten Masken, bei denen eine Erhöhung der mechanischen Stabilität immer mit einer Verschlechterung der Übertragungsqualität erkauft werden muss. Der genannte grosse Vorteil der erfindungsgemässen Maske ergibt sich daraus, dass das in der Metallschicht bzw. in den Metallschichten ausgebildete Maskenmuster über das Muster in der dotierten Schicht in definierter Weise lateral hinausragt. Dadurch ist sichergestellt, dass im Bereich der Lochkanten in der Metallschicht die Maske so dünn ist, dass Streueffekte in keinem Fall zu befürchten sind. Anderseits lässt sich die Maske mit dem erfindungsgemässen Verfahren ohne weiteres so ausbilden, dass die Maskendicke im Bereich der Lochkanten in der Metallschicht so gleichmässig dick gemacht werden kann, dass auch dann, wenn die Maskendicke in der Nähe des für die vollständige Absorption der Elektronen notwendigen Mindestwerts liegt, sichergestellt ist, dass an keiner Stelle Elektronen das Maskenmaterial durchdringen. Wird als Metall Gold oder ein anderes ähnlich dichtes Material verwendet, so kann bei einer typischen Elektronenenergie von 25 keV die Metallschicht unter 1 µm sein, ohne dass eine unvollständige Absorption der Elektronen zu befürchten ist. Mit der erfindungsgemässen Maske lassen sich beliebig geformte Musterelemente übertragen, solange sie nicht ringförmig bzw. in sich geschlossen sind. Zur Übertragung von in sich geschlossenen Musterelementen werden zwei Masken benötigt, worauf in der Beschreibung noch eingegangen wird. Aufgrund ihrer thermischen Stabilität, worunter zu verstehen ist, dass auch dann, wenn die Maske ein hoher Elektronenstrom (Grösserordnung 50 bis 100 µA) trifft, keine Beeinträchtigung der Übertragungsqualität von Mustern infolge einer Verzerrung der Maske zu befürchten ist, lässt sich mit der erfindungsgemässen Maske ein hoher Durchsatz erzielen. Die thermische Stabilität der Maske und damit der erzielbare Durchsatz lässt sich noch dadurch in vorteilhafter Weise steigern, dass man dafür sorgt, dass die dotierte Schicht hoch mit Bor dotiert ist. Die in das Siliciumgitter eingebauten Boratome bewirken eine Spannung in der aus der dotierten Schicht beim Dünnätzen entstehenden Folie, die im Fall der erfindungsgemässen Maske erst durch eine Temperaturerhöhung um 120 °C wieder kompensiert wird. Diese Spannung bewirkt einerseits eine hohe thermische Festigkeit der erfindungsgemässen Maske und führt anderseits, wie mit Hilfe der Methode der finiten Elemente gezeigt werden konnte, nicht zu kritischen Verzerrungen des Maskenmusters (das Lochmuster darf nicht mehr als ca. 0,1 µm verzerrt sein). Ein einkristallines Substrat begünstigt das Entstehen der vorteilhaften, nicht verzerrenden Spannung in der Folie. Mit der bordotierten Maske kann unter Zugrundelegung einer Spannweite der dünnen Maskenausschnitte bzw. der Folien von 6 × 6 mm ein so hoher Elektronenstrom angewandt werden, dass in 80 Millisekunden eine 5 × 5 mm grosse Fläche mit einer ausreichenden Intensität bestrahlt werden kann, während mit dem oben erwähnten Elektronenstrahlmustergenerator für die gleiche Fläche eine Bestrahlungszeit grösser 1 Sekunde benötigt wird.

Ein hoher Durchsatz lässt sich mit der erfindungsgemässen Maske auch dann erzielen, wenn die Maske nur so gross ist, dass sie nur einen Teil eines zu bestrahlenden Substrats bedeckt, d.h. auch dann, wenn bei einem Bestrahlungsvorgang immer nur ein Teil des Substrats bestrahlt werden kann und bis zur vollständigen Bestrahlung die Schrittfolge: Maske gegenüber dem Substrat verschieben, Maske zum Substrat ausrichten, Bestrahlen, mehrmals wiederholt werden muss.

Das Verfahren zur Herstellung der erfindungsgemässen Maske ist leicht zu steuern. Dies trifft auch für den entscheidenden Schritt des Unterätzens der Metallschicht zu, bei dem es ohne weiteres möglich ist, Unterätzungen von Bruchteilen von µm reproduzierbar innerhalb sehr kleiner Toleranzen zu erzeugen.

Als weiterer Vorteil des erfindungsgemässen Verfahrens kommt hinzu, dass bei seiner Anwendung Vorrichtungen, Chemikalien und zum Teil auch Techniken, welche in der Halbleitertechnik ohnehin benutzt werden, eingesetzt werden können.

Weitere vorteilhafte Ausgestaltungen der erfindungsgemässen Maske und des erfindungsgemässen Verfahrens sind in den Unteransprüchen aufgeführt.

Die Erfindung wird anhand von durch Zeichnungen erläuterten Ausführungsbeispielen beschrieben. Es zeigen:

Fig. 1 in einer schematischen Querschnittsdarstellung einen Ausschnitt aus einer Ausführungsform der Maske gemäss der Erfindung;

Fig. 2A bis 2I in schematischen Querschnittsdarstellungen Ausschnitte aus Metall-Halbleiterschichtstrukturen in verschiedenen Stadien der Herstellung einer erfindungsgemässen Maske gemäss dem erfindungsgemässen Verfahren.

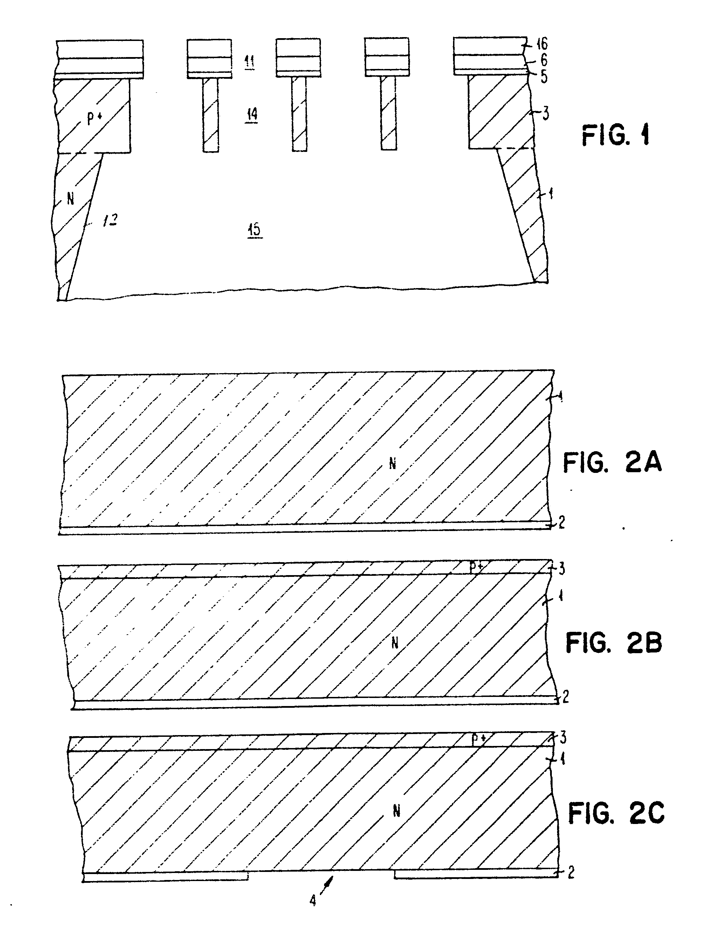

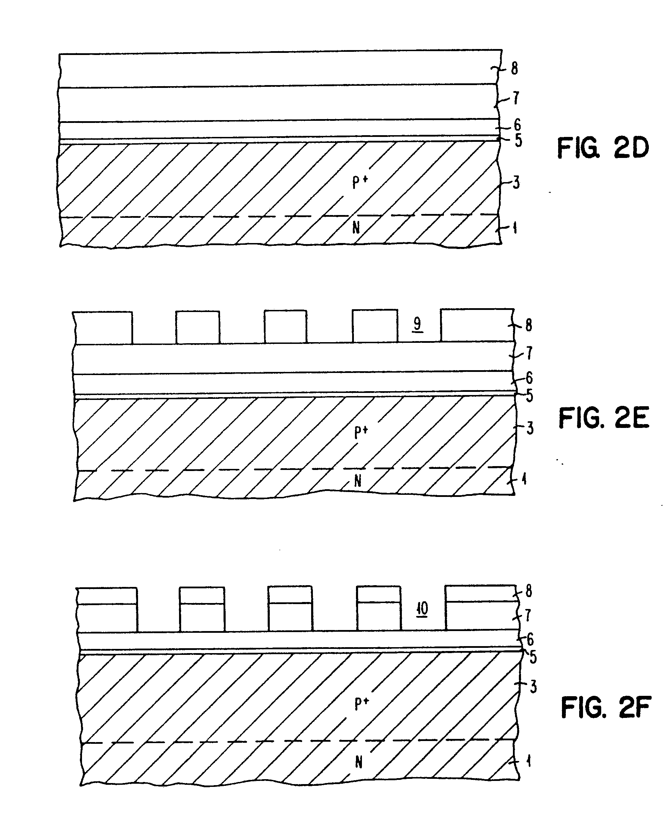

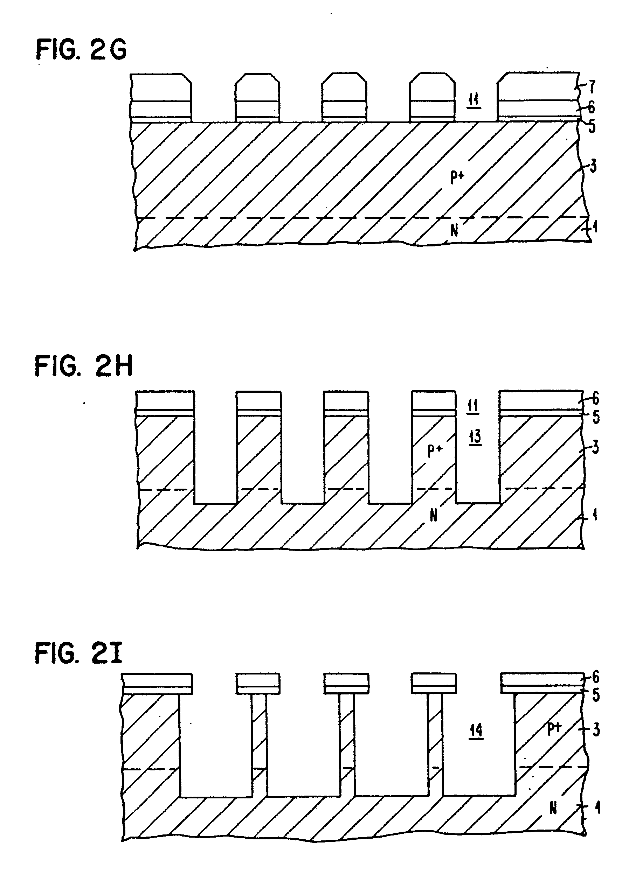

Anhand der Fig. 1 und 2 werden im folgenden zwei Ausführungsformen der erfindungsgemässen Maske besprochen.

In der Fig. 1 ist in einer schematischen Querschnittsdarstellung ausschnittsweise ein Siliciumplättchen gezeigt, welches eine Oberflächenschicht 3 aufweist, welche sich durch ihre $P^+$-Dotierung vom übrigen N-dotierten Material (Substrat 1) unterscheidet. Auf der $P^+$-dotierten Schicht 3 ist eine dünne Chromschicht 5 und darüber 2 Goldschichten 6 und 16 aufgebracht. Durch die Metallschichten (16, 6, 5) gehen Löcher bzw. Fenster 11 hindurch, welche das Maskenmuster definieren und deren Wände im wesentlichen senkrecht zur Substratoberfläche verlaufen. Die Löcher 11 erweitern sich in der darunterliegenden Schicht 3 zu breiteren Löchern 14. Die Löcher 14 entsprechen zwar noch dem Maskenmuster, da sie jedoch breiter als die Löcher 11 sind, bilden die Metallschichten 5, 6 und 16, in welchen das Maskenmuster ausgebildet ist, über der Struktur in der Siliciumschicht 3 einen Überhang. Wannenförmige Vertiefungen 15 erstrecken sich von der den Metallschichten abgewandten (in der Fig. 1 nicht gezeigten) Oberfläche des Siliciumplättchens soweit in das Substrat hinein, dass die Löcher 14 zur Wanne 15 hin geöffnet sind. Ein Siliciumplättchen kann eine grössere Anzahl von wannenförmigen Vertiefungen 15 aufweisen, welche durch aus Bereichen des Substrats 1 gebildeten, netzförmig angeordneten Rippen 12 voneinander getrennt sind. Bevorzugt ist jede einzelne wannenförmige Vertiefung 15 einem in sich abgeschlossenen Maskenausschnitt in der Weise zugeordnet, dass alle diesem Maskenausschnitt zugeordneten Löcher sich in diese wannenförmige Vertiefung 15 hinein öffnen. Ein solcher in sich abgeschlossener Maskenausschnitt ist beispielsweise der einem Chip auf einem Halbleiterplättchen zugeordnete Maskenbereich, weshalb dann in diesem Fall die lateralen Abmessungen der wannenförmigen Vertiefungen 15 auf die Chipgrösse abgestimmt sind. Chipgrössen von 6 × 6 mm sind heute bereits üblich. Wenn es sich bei dem in der Maske verwendeten Siliciumsubstrat um ein einkristallines Siliciumplättchen mit einer (100)-Orientierung handelt, weisen die Wände der wannenförmigen Vertiefungen 15 eine Neigung von ca. 54° auf.

Ist das Siliciumplättchen ein kommerziell erhältliches, so hat dieses typischerweise eine Dikke von ungefähr 400 µm. Die Dicke des Siliciumsubstrats in der Maskenstruktur kann allerdings geringer sein als die Dicke des Siliciumplättchens, bei dem von seiner Herstellung ausgegangen wird. Dies muss beispielsweise dann der Fall sein, wenn die den einzelnen wannenförmigen Vertiefungen 15 zugeordneten Maskenausschnitte einen Abstand voneinander haben sollen, welcher kürzer ist als die Strecke zwischen den Wänden zweier benachbarter wannenförmiger Vertiefungen 15 an ihrem tiefsten Punkt, welche sich unter Berücksichtigung des oben erwähnten 54° Winkels und einer Substratdicke von 400 µm ergibt. Die Oberflächenschicht vom $P^+$-Typ, welche bevorzugt mit Bor dotiert ist, hat eine Dicke im Bereich zwischen etwa 1 und etwa 4 µm. Die Dotierung der $P^+$-dotierten Schicht fällt senkrecht zur Substratoberfläche mit zunehmender Entfernung von dieser ab und die Dicke der $P^+$-dotierten Schicht ist definiert als derjenige Abstand von der Substratoberfläche, bei welchem die Dotierung auf einen Wert von $7 \times 10^{19}$ Atomen/cm³ abgefallen ist. Die minimale Breite der Löcher 13 liegt unterhalb 1 µm. Die Chromschicht zwischen dem Siliciumsubstrat und den Goldschichten ist sehr dünn und hat typischerweise eine Dicke von ungefähr 0,02 µm. Die Goldschichten haben eine Gesamtdicke von $\leq 1$ µm.

Gold ist deshalb ein vorteilhaftes Maskenmaterial, weil es eine gute Wärmeleitfähigkeit und eine hohe Dichte aufweist. Die gute Wärmeleitfähigkeit verhindert eine zu rasche Erwärmung der Maske, wenn sie mit einem Elektronenstrahl bestrahlt wird und die hohe Dichte bewirkt, dass relativ energiereiche Elektronen bereits in einer dünnen Goldschicht vollständig absorbiert werden. Eine Goldschicht von ungefähr 0,8 µm Dicke reicht aus, um Elektronen einer Energie von 25 keV vollständig zu absorbieren. Um energiereichere Elektronen zu absorbieren, muss man die Dicke der Goldschicht erhöhen, jedoch ist dabei zu beachten, dass wegen des unterschiedlichen Ausdehnungskoeffizienten von Silicium und Gold bei der unvermeidlichen Erwärmung der Maske, wenn sie mit Elektronen bestrahlt wird, beim Vorliegen von zu dicken Goldschichten eine unerwünschte und nicht tolerierbare Verbiegung der Maske eintreten kann. Dass zwei Goldschichten vorhanden sind, ergibt sich aus dem weiter unten besprochenen Herstellungsprozess, bei dem zunächst in einer Goldschicht, welche zu dünn ist, um die Elektronen der üblicherweise angewandten Energie vollständig zu absorbieren, das Maskenmuster erzeugt wird, und in einem späteren Verfahrensschritt das Maskenmuster durch Aufbringen von zusätzlichem Gold so verstärkt wird, dass es die notwendige Dicke hat. Die sehr dünne Chromschicht dient als Haftvermittler zwischen dem Siliciumsubstrat und der Goldschicht. Aufgabe des rippenförmigen Netzes zwischen den wannenförmigen Vertiefungen 15 aus N-dotiertem Substratmaterial ist es, der Maske eine ausreichende Stabilität zu geben, so dass sie mechanischen und thermischen Belastungen widerstehen kann und dass sie auch in einer fabrikmässigen Fertigung gehandhabt werden kann, ohne dass sie beschädigt wird, wenn sie mit angemessener Sorgfalt behandelt wird. Das rippenförmige Netz kann diese stabilisierende Wirkung aufgrund seiner relativ grossen Dicke erbringen. Trotzdem die einzelne Rippe 12 relativ viel Platz braucht, ist der Platzbedarf aller Rippen 12 bezogen auf die Gesamtfläche der Maske relativ gering, und zwar deshalb, weil bei der erfindungsgemässen Maske die Flächen der Maskenausschnitte zwischen benachbarten Rippen 12 beachtlich gross sein können.

Die Lochstruktur in der $P^+$-dotierten Schicht 3 unterstützt das Maskenmuster in den Goldschichten und gibt der Maske innerhalb der Maskenausschnitte zwischen den Rippen 12 ihre thermische und mechanische Stabilität. Dazu ist es notwendig, dass die Schicht 3 eine Mindestdicke aufweist, auch wenn sie hoch bordotiert und deshalb sehr fest ist. Um mit der Maske einen hohen Durchsatz zu erzielen, muss sie mit einem möglichst intensiven Elektronenstrahl bestrahlt werden. Deshalb muss die Maske thermisch belastbar sein; denn je intensiver der Strahl ist, desto stärker erwärmt sich dabei die Maske. Beispielsweise erwärmt sich bei einem Strahlstrom von 60 µA und einer Elektronenenergie von 25 keV die Maske auf ungefähr 100 °C. Wird der Strahlstrom unter sonst gleichen Bedingungen auf 100 µA erhöht, so erwärmt sich die Maske auf 200 °C. Auf der anderen Seite muss beachtet werden, dass der Trend in der Halbleitertechnik zu immer dichter gepackten Schaltungen und zu immer kleineren Schaltungselementen geht. Entsprechend kleiner müssen die Musterelemente in den Masken werden. Heutzutage sind Musterelemente mit Breiten $\leq 1$ µm nicht mehr ungewöhnlich. Hätten die Löcher 14 dieselben lateralen Abmessungen wie die Löcher 11, d.h. würden die Maskenöffnungen mit konstantem Querschnitt durch die Metallschichten und die Schicht 3 hindurchgehen, so würden, wenn die Löcher schmäler als 1 µm werden, und die Dicke der Schicht 3 aus Gründen der Stabilität bei 3 bis 4 µm liegt, beim Bestrahlen mit einem Elektronenstrahl Streueffekte auftreten, welche die Kantendefinition des übertragenen Musters verschlechtern und deshalb eine genaue Übertragung des Maskenmusters unmöglich machen. Bei den erfindungsgemässen Masken tritt dieses Problem nicht auf, weil das Maskenmuster in den Metallschichten (5, 6, 16) über die Struktur in der Schicht 3 überhängt. Dadurch wird einerseits die Maskenmusterdicke auf die Dicke der Metallschichten reduziert, wodurch die Gefahr von Streueffekten eliminiert wird, andererseits wird das Maskenmuster nach wie vor von der Struktur in der Schicht 3 gestützt, welche nun unabhängig von der Breite der Fenster im Maskenmuster so dick sein kann, wie es für eine optimale Stabilisierung des Maskenausschnitts unter den Bedingungen, unter denen die Maske benutzt wird, notwendig ist.

Das Makenmuster muss nicht notwendigerweise in einer Goldschicht bzw. in einer aus einer dünnen Chrom- und einer Goldschicht zusammengesetzten Beschichtung ausgebildet sein. Geeignet sind alle Metalle, welche eine hohe Dichte und eine gute Wärmeleitfähigkeit aufweisen und in denen mittels der zur Verfügung stehenden Verfahren das Maskenmuster – auch ein solches mit sehr kleinen Musterelementen – mit der notwendigen Genauigkeit erzeugt werden kann. Ausserdem muss das Metall auf dem Substrat gut haften. Als Substratmaterialien empfehlen sich ausser Silicium auch noch andere Halbleitermaterialien, wie Galliumarsenid oder Germanium. Diese Materialien sind deshalb so vorteilhaft, weil für die genaue und reproduzierbare Erzeugung von sehr kleinen und komplexen Strukturen in diesen Materialien dank der intensiven und lang dauernden Entwicklungsarbeit auf dem Halbleitergebiet ein grosses fachmännisches Wissen und insbesondere auch die apparativen Voraussetzungen vorhanden sind. Hinzu kommt, dass Halbleitermaterial so dotiert werden kann, dass Bereiche, wie z.B. die $P^+$-dotierte Schicht 3 in der Fig. 1 entstehen, welche sich gegenüber einem Ätzangriff völlig anders verhalten können als die Bereiche des Materials, welche nicht der Dotierungsoperation unterworfen worden sind.

Um den erwähnten günstigen Dotierungseffekt zu erzielen, ist es nicht unbedingt notwendig, dass man eine $P^+$-dotierte Oberflächenschicht mit einem sonst N-dotierten Substrat kombiniert. Der gewünschte Effekt tritt beispielsweise auch dann ein, wenn die Oberflächenschicht N-dotiert und das übrige Substrat $N^+$-dotiert ist. Allerdings ist – wie schon oben ausgeführt wurde – eine $P^+$-Dotierung wegen des festigenden Einflusses des Bors auf das Silicium zusätzlich vorteilhaft.

Die Maske kann entweder – wovon oben ausgegangen wurde – die Grösse eines üblichen Halbleiterplättchens haben und durch die Rippen 12 zwischen den wannenförmigen Vertiefungen 15 in Maskenausschnitte unterteilt sein, deren laterale Abmessungen beispielsweise auf die Grösse eines üblichen Halbleiterchips abgestimmt ist, oder die Maske umfasst nur die durch eine oder zwei wannenförmige Vertiefungen 15 definierte Fläche, d.h. hat nur die laterale Abmessungen von beispielsweise ein oder zwei Halbleiterchips.

Anhand der Fig. 2A bis 2I soll nun das erfindungsgemässe Verfahren zur Herstellung einer Maske, wie sie schematisch in der Fig. 1 dargestellt ist, beschrieben werden.

Als Substrat 1 wird ein N-dotiertes, einkristallines Siliciumplättchen mit (100)-Orientierung verwendet, welches typischerweise eine Dicke von ungefähr 400 µm hat, aber auch zwischen ungefähr 100 und 400 µm dick sein kann. Die eine Oberfläche des Substrats 1 (im folgenden Rückseite genannt) wird mit einer 0,5 bis 1 µm dicken Siliciumoxidschicht 2 versehen. Dazu wird das Siliciumplättchen 1 beispielsweise thermisch oxidiert, indem es eine festgelegte Zeit lang bei einer Temperatur von ungefähr 1000 °C einer Sauerstoff/Wasserdampfatmosphäre ausgesetzt wird und nach dem Abkühlen die auf der von der Rückseite abgewandten Oberfläche (im folgenden Vorderseite genannt) aufgewachsene Oxidschicht abgelöst wird. Die dabei gebildete Struktur zeigt in einem Querschnitt durch das Siliciumplättchen ausschnittsweise die Fig. 2A.

Anschliessend wird das Substrat 1 von der Vorderseite her mit einer eine $P^+$-Leitfähigkeit vermittelnden Verunreinigung hoch dotiert. Es ist günstig, als Verunreinigung Bor zu verwenden.

Zur Dotierung werden entweder in bekannter Weise Ionen der Verunreinigung implantiert oder wird die Verunreinigung eindiffundiert, wobei die Diffusion bei hohen Temperaturen entweder in einer evakuierten Kapsel unter Verwendung von bordotiertem Silicium als Diffusionsquelle oder im offenen Rohr vorgenommen wird, wobei ein Trägergasstrom, welcher als Borquelle bevorzugt $BBr_3$ enthält, über die Halbleiterplättchen strömt. Bei der Dotierung entsteht die $P^+$-dotierte Oberflächenschicht 3, in welcher die Dotierung an der Oberfläche am grössten ist und deren Dotierung mit dem Abstand zur Oberfläche abnimmt und deren Dicke als der Abstand von der Oberfläche definiert ist, bei dem die Dotierungskonzentration $7 \times 10^{19}$ Verunreinigungsatome/cm² ist. Die dann vorliegende Struktur zeigt im Querschnitt die Fig. 2B. Grundsätzlich kann die Schicht 3 auch eine auf das Substrat 1 aufgebrachte Epitaxieschicht sein.

Mittels eines photolithographischen Ätzverfahrens wird bzw. werden nun eine Öffnung bzw. Öffnungen 4 in die Oxidschicht 2 auf der Plättchenrückseite erzeugt (siehe Fig. 2C). Die lateralen Abmessungen der Öffnung bzw. der Öffnungen 4 sind bestimmt durch die lateralen Abmessungen der in einem späteren Verfahrensschritt zu ätzenden wannenförmigen Vertiefungen.

Um die bei den folgenden Verfahrensschritten interessierenden Details besser zu illustrieren, zeigen die Fig. 2D bis 2I – anders als die Fig. 2A bis 2C, welche Querschnitte durch die gesamte Dicke des Halbleiterplättchens darstellen – vergrösserte Ausschnitte aus den vorderseitigen Oberflächenbereichen der herzustellenden Maskenstruktur.

Auf die Plättchenvorderseite wird nun eine dünne Chromschicht 5, welche typischerweise eine Dicke von 0,02 µm hat und darüber eine ungefähr 0,3 µm dicke Goldschicht 6 mittels konventionellen Aufdampfens aufgebracht. Auf der Goldschicht 6 wird eine ungefähr 0,8 µm dicke Siliciumdioxidschicht 7 bei einer Temperatur $\leq$ ungefähr 600 °C bevorzugt mittels chemischen Niederschlagens aus der Dampfphase oder mittels Kathodenzerstäubens aufgewachsen. Auf der Siliciumdioxidschicht 7 wird eine ungefähr 0,5 bis ungefähr 1 µm dicke Schicht 8 aus einem strahlungsempfindlichen Lack durch Aufschleudern aufgebracht. Die dann vorliegende Struktur zeigt die Fig. 2D im Querschnitt. Der strahlungsempfindliche Lack muss, da ein sehr hoch aufgelöstes Maskenmuster erzeugt werden soll, elektronenstrahlempfindlich sein.

Mittels eines Elektronenstrahl-Muster-Erzeugers wird nun die Lackschicht 8 selektiv entsprechend dem gewünschten Maskenmuster bestrahlt. Anschliessend wird entwickelt, wobei von der Lackschicht 8 ein Muster übrig bleibt, welches das gewünschte Maskenmuster exakt wiedergibt. Mit den besten heute kommerziell erhältlichen Elektronenstrahl-Muster-Erzeugern ist man bei einer Lackschichtdicke zwischen ungefähr 0,5 und ungefähr 1 µm in der Lage, Linien mit einer Breite von $\leq 1$ µm mit höchster Präzision in die Lackschicht zu übertragen. Nach dem Entwickeln liegt eine Struktur, wie sie die Fig. 2E im Querschnitt zeigt, vor.

Im folgenden Verfahrensschritt wird mittels reaktiven lonenätzens in einer CHF$_3$ oder ein CF$_4$/H$_2$-Gemisch enthaltenden Atmosphäre die SiO$_2$-Schicht 7 unter Verwendung der Lackmaske 8 selektiv, d.h. dort, wo sich in der Lackmaske 8 die Öffnungen 9 befinden, weggeätzt. Zum reaktiven lonenätzen wird ein planares Kathodensystem verwendet, in dem ein Druck von ca. 40 m Torr herrscht. Die HF-Leistung liegt bei ca. 0,2 Watt/cm$^2$ und bei Verwendung von CF$_4$ und H$_2$ liegt das Flussratenverhältnis CF$_4$:H$_2$ bei ungefähr 3,5:1. Dabei kann das in der Lackschicht ausgebildete Muster mit hoher Masstreue auch dann in eine – wie die vorliegende – relativ dicke SiO$_2$-Schicht geätzt werden, wenn das Muster Linienbreiten von ≤ 1 μm aufweist. Bei dem reaktiven lonenätzen wird die Lackschicht 8 zu einem geringen Teil abgebaut. Die Öffnungen in der Siliciumdioxidschicht 7 haben zur Substratoberfläche senkrechte Wände und fluchten genau mit den Öffnungen in der Lackschicht 8. Die dann vorliegende Struktur zeigt die Fig. 2F im Querschnitt, in welcher die dem Maskenmuster entsprechenden Öffnungen nun mit der Nummer 10 bezeichnet sind.

Die nun freiliegenden Bereiche der Goldschicht 6 und die darunterliegenden Bereiche der dünnen Chromschicht 5 werden mittels lonenätzens mit Argonionen weggeätzt. Die Struktur sieht nach dem lonenätzen so aus, wie sie die Fig. 2G im Querschnitt wiedergibt. Die dem Maskenmuster entsprechenden Öffnungen sind in der Fig. 2G mit der Nummer 11 bezeichnet. Das lonenätzen mit Argonionen ist ein Ätzprozess mit niedriger Ätzrate und geringer Selektivität. Deshalb wurde die Goldschicht nur 0,3 μm dick abgeschieden. Bei dem lonenätzen wird unter folgenden Bedingungen gearbeitet:

Ätzanlage: planares Kathodensystem mit Argon-Plasma oder gute Hochvakuumanlage mit darin befindlicher (Ar)-lonenstrahlerzeugungsquelle;

Druck: 10$^{-3}$ Torr;

Energie der Argonionen: ca. 1 keV.

Im folgenden Verfahrensschritt wird die P$^+$-dotierte Siliciumschicht 3 selektiv geätzt. Dabei wird ein reaktives lonenätzverfahren angewandt, bei dem in einer Argon und Chlor enthaltenden Atmosphäre gearbeitet wird. Die Struktur in der ungefähr 0,8 μm dicken SiO$_2$-Schicht 7 dient dabei als Ätzmaske. Die Bedingungen beim Ätzen können ohne weiteres so gewählt werden, dass ein Ätzgeschwindigkeitenverhältnis zwischen SiO$_2$ und Si von 1:10 erreicht werden kann. Wird bei dem Verfahren mit einem planaren Kathodensystem bei einem Druck von ca. 1 × 10$^{-2}$ Torr in einer Atmosphäre, welche 97 Volumprozent Argon und 3 Volumprozent Chlor enthält, gearbeitet, so werden in die P$^+$-dotierte Siliciumschicht 3 Löcher mit zur Substratoberfläche senkrechten Wänden geätzt. Eine Unterätzung ist nicht feststellbar. Beim Ätzen der Schicht 3 wird auch die Schicht 7 allmählich abgetragen (SiO$_2$-Reste, die dann noch vorhanden sind, werden am besten durch Eintauchen in gepufferte Flusssäure entfernt). Nach dem Ätzen der Schicht 3 liegt die in der Fig. 2H im Querschnitt gezeigte Struktur vor. Die dem Maskenmuster entsprechenden Löcher in der Schicht 3 sind in der Fig. 2H mit der Nummer 13 bezeichnet. Die Tiefe, bis zu der in das Silicium hineingeätzt wird, ist völlig unkritisch, sie muss lediglich grösser sein als die definierte Dicke der P$^+$-dotierten Schicht 3.

Im nächsten Verfahrensschritt werden die Löcher 13 in der P$^+$-dotierten Schicht 3 zu Löchern 14 erweitert. Bei diesem Verfahrensschritt kommt es darauf an, die Chromschicht 5 und die Goldschicht 6 um einen genau festgelegten Betrag zu unterätzen. Dabei einsetzbar ist ein Plasmaätzverfahren, mit welchem P$^+$-dotiertes Silicium in einer Kohlenstofftetrafluorid enthaltenden Atmosphäre mit einer Ätzgeschwindigkeit im Bereich zwischen etwa 20 und ungefähr 40 nm/Minute geätzt werden kann. Mit diesem Plasmaätzverfahren werden jedoch keine völlig befriedigenden Ergebnisse erzielt.

Besser geeignet zum Unterätzen ist eine Nassätzung unter Verwendung einer Ätzlösung, welche aus Äthylendiamin, Brenzkatechin, Wasser und u.U. Wasserstoffperoxid besteht. Bevorzugt besteht die Lösung aus 72 g Brenzkatechin, 630 ml Äthylendiamin, 115 ml Wasser und 29 ml H$_2$O$_2$ und wird bei Temperaturen < 118 °C eingesetzt. Diese Lösung hat die Eigenschaft, dass sie einkristallines Silicium, welches N- bzw. nicht P$^+$-dotiert ist, anisotrop (100-Ebenen werden zirka sechzehnmal schneller als 111-Ebenen geätzt) und – wie man bisher annahm – P$^+$-dotiertes Silicium überhaupt nicht ätzt. Bei Untersuchungen, welche im Zusammenhang mit der vorliegenden Erfindung gemacht wurden, wurde allerdings festgestellt, dass auch P$^+$-dotiertes Silicium von der Ätzlösung etwas angegriffen wird; und zwar ätzt diese Ätzlösung P$^+$-dotiertes Silicium mit einer Ätzgeschwindigkeit von ≤ 10 nm/Minute isotrop. Infolgedessen ist diese Ätzlösung gut geeignet, um die gewünschte Unterätzung durchzuführen. Bei diesem Unterätzen wird auch das N-dotierte Substratmaterial – und zwar mit einer relativ grossen Geschwindigkeit – angeätzt. Dies ist jedoch völlig unkritisch, da dieses Material beim Ätzen der wannenförmigen Vertiefungen 15 ohnehin entfernt werden würde. Beim Unterätzen wird eine Struktur erhalten, wie sie die Fig. 2I im Querschnitt wiedergibt.

Für die exakte Unterätzung ist auch ein Trokkenätzverfahren sehr gut geeignet, welches Silicium sehr langsam isotrop abträgt. Dabei wird in einer Vakuumkammer (ohne ein Plasma) mit Fluor (F$_2$) geätzt. Man geht dabei von festem Xenondifluorid (XeF$_2$) aus, welches sich in einem Behälter befindet. Dieser ist über ein Ventil mit der Vakuumkammer, in der sich das zu ätzende Substrat befindet, verbunden. Bei einem Druck von ≤ ungefähr 10 Torr zersetzt sich XeF$_2$ und das freiwerdende F$_2$ strömt in die Vakuumkammer.

Nach dem Unterätzen erfolgt das Ätzen der wannenförmigen Vertiefungen 15 von der Plättchenrückseite her, wobei die Siliciumdioxidschicht 2 mit den Öffnungen 4 als Ätzmaske dient. Zum Ätzen wird die auch zum Unterätzen brauchbare Lösung aus Äthylendiamin, Brenzkatechin, Wasser und u.U. Wasserstoffperoxid (bevorzugte Zusammensetzung s.o.) bei einer Temperatur von $\leq 118\,°C$ verwendet. Beim Ätzen der wannenförmigen Vertiefungen wird die Plättchenvorderseite mit einer Ätzkappe, welche den Angriff der Ätzlösung verhindert, abgedeckt. Die Steuerung des Ätzens der wannenförmigen Vertiefungen 15 ist aufgrund der genannten Eigenschaften der Ätzlösung sehr einfach; genau genommen wird die Ätzung durch die Bedingungen, unter welchen die Dotierung der Schicht 3 erfolgt ist, bestimmt. Der Ätzvorgang senkrecht zur Plättchenoberfläche kommt nämlich vollständig – bzw. nach den neuen Erkenntnissen weitgehend – zum Stillstand, wenn im Bereich der Löcher 4 soviel von dem Substratmaterial abgetragen worden ist, dass die Ätzlösung von der Rückseite her dort mit der $P^+$-dotierten Schicht 3 in Berührung kommt, wo deren Verunreinigungskonzentration $\geq 7 \times 10^{19}$ Atome/$cm^3$ ist. Nach dem Ätzen der wannenförmigen Vertiefungen liegt – wenn man von der zweiten Goldschicht 16 absieht – eine Struktur vor, welche die Fig. 1 im Querschnitt wiedergibt und welche die aus Bereichen des Substrats 1 gebildeten Rippen 12 enthält.

Als letzter Verfahrensschritt wird – soweit erforderlich – die Goldschicht 6 durch eine zusätzliche Goldschicht 16 auf die für eine vollständige Absorption der mit einer festgelegten Energie auftreffenden Elektronen erforderliche Mindestdicke verstärkt. Wie schon erwähnt, ist es ungünstig, die Goldschichten dicker als notwendig zu machen. Das Aufbringen der Goldschicht 16 erfolgt bevorzugt durch Aufdampfen, wobei es notwendig ist, eine möglichst punktförmige Aufdampfquelle, welche eine möglichst grosse Entfernung von der Maskenstruktur hat, zu verwenden, um eine laterale Änderung der Maskenstruktur zu verhindern.

Die nun vorliegende Maskenstruktur ist in der Fig. 2 ausschnittsweise im Querschnitt gezeigt.

Das oben angegebene Verfahren lässt sich aufgrund von Versuchen, welche im Rahmen des fachmännischen Handels liegen, leicht entsprechend abwandeln, wenn andere Materialien – wie oben angegeben – für das Substrat, die Metallschicht bzw. die Metallschichten, in welcher bzw. in welchen das eigentliche Maskenmuster erzeugt wird, oder zum Dotieren verwendet werden.

Die erfindungsgemässen Masken lassen sich immer dann verwenden, wenn auf «photo»-lithographischem Weg Strukturen in strahlungsempfindlichen Lacken erzeugt werden sollen. Solche Lackstrukturen werden beispielsweise bei der Herstellung von mikrominiaturisierten Schaltungen in Halbleiterplättchen und bei der Herstellung von magnetischen Zylinderdomänenspeicher-Bauteilen als Ätzmaske und als Abhebe (lift-off)-Masken verwendet. Mit den erfindungsgemässen Masken lassen sich Muster in strahlungsempfindliche Lackschichten übertragen, welche Musterelemente mit Breiten $< 1\,\mu m$ aufweisen. Die Übertragung solcher Muster ist zwar auch mit den bekannten Elektronenstrahl-Muster-Erzeugern möglich, jedoch kann man mit diesen bekannten Geräten nicht mit einem so hohen Durchsatz arbeiten, wie er für eine Massenfertigung erforderlich ist. Die erfindungsgemässen Masken haben ausser dem Vorteil, dass sie Muster mit höchster Präzision übertragen können, den weiteren Vorteil, dass sich mit ihnen ein hoher Durchsatz erzielen lässt. Dies ist deshalb möglich, weil die erfindungsgemässe Maske mit ungewöhnlich hohen Elektronenströmen bestrahlt werden kann, ohne dass dabei eine untolerierbar starke Verzerrung der Masken eintritt. Hohe Elektronenströme führen also nicht dazu, dass die zu übertragenden Muster verzerrt sind, gewährleisten jedoch hohe Elektronenströme einen hohen Durchsatz. Für die vollständige Bestrahlung eines runden Halbleiterplättchens mit einem Durchmesser von ungefähr 82 mm werden bei Zugrundelegung eines Elektronenstromes von 60 µA acht Sekunden benötigt. Dabei wird vorausgesetzt, dass die erfindungsgemässe Maske das zu erzeugende Muster vollständig wiedergibt. Soll ein Halbleiterplättchen bestrahlt werden, welches aus einer grossen Anzahl von völlig gleichen Chips zusammengesetzt ist, und gibt die erfindungsgemässe Maske ein Muster wieder, welches nur einer Chipgrösse entspricht, d.h. wenn nach jeder Bestrahlung eines Chips die Maske gegenüber den Halbleiterplättchen um eine Chipbreite verschoben werden muss, so erhöht sich die zur Bestrahlung des gesamten Plättchens notwendige Zeitdauer auf ca. 90 Sekunden, wobei von ca. 200 Chips auf dem Halbleiterplättchen ausgegangen wird.

Bei der Bestrahlung wird so vorgegangen, dass in einer Justiervorrichtung die erfindungsgemässe Maske zu dem mit dem strahlungsempfindlichen Lack beschichteten, zu bearbeitenden Werkstück, beispielsweise einem Halbleiterplättchen, ausgerichtet und dann mit seiner Vorderseite in einen Abstand von $<$ ungefähr 500 µm gebracht wird und dass dann mit einem Elektronenstrahl mit einem bevorzugten Durchmesser von ca. 1 mm die Maske von der Rückseite her Zeile für Zeile überstrichen wird, bis jeder Punkt der Maske sich im Strahlengang befunden hat.

Es ist einleuchtend, dass es mit der erfindungsgemässen Maske, welche ja wegen der starken Absorption von Elektronen in Materie durchgehende Löcher aufweisen muss, nicht möglich ist, ringförmige bzw. in sich geschlossene Musterelemente zu übertragen. Dieser Schwierigkeit kann dadurch begegnet werden, dass zwei Masken verwendet werden, welche in der Weise sich ergänzende Teile des ringförmigen Musterelementes enthalten, dass, wenn die Lackschicht durch beide Masken bestrahlt wird, das ringförmige Musterelement latent entsteht. Ein solches Verfahren ist in der DE-A-2 739 502 beschrieben.

## Patentansprüche

1. Maske zum Strukturieren von Oberflächenbereichen mit Hilfe von Korpuskular- oder Röntgenstrahlen, welche aus mindestens einer Metallschicht mit durchgehenden, das Maskenmuster definierenden Fenstern und einem Halbleiterplättchen besteht, auf welchem die Metallschicht aufgebracht ist und welches dem Maskenmuster entsprechende durchgehende Löcher aufweist, welche sich von der mit der Metallschicht bedeckten Oberfläche (Vorderseite) bis zu mindestens einer wannenförmigen Vertiefung erstrecken, welche sich von der anderen Plättchenoberfläche (Rückseite) in das Halbleitermaterial hineinerstreckt, dadurch gekennzeichnet, dass die Löcher (14) in einer Oberflächenschicht (3) im Halbleitersubstrat ausgebildet sind, welche sich in ihrer Dotierung vom übrigen Substrat (1) unterscheidet und dass die Löcher (14) in ihren lateralen Abmessungen grösser als die Fenster (11) in der Metallschicht bzw. in den Metallschichten (5, 6, 16) sind, so dass die Metallschicht bzw. die Metallschichten (5, 6, 16) über die genannte Oberflächenschicht (3) übersteht.

2. Maske nach Anspruch 1, dadurch gekennzeichnet, dass die Metallschicht aus einer Goldschicht bzw. die Metallschichten aus einer Chromschicht (5) und aus Goldschichten (6, 16) bestehen bzw. bestehen.

3. Maske nach Anspruch 1 oder 2, dadurch gekennzeichnet, dass die Metallauflage so dick ist, dass zum Bestrahlen verwendete Elektronen vollständig in ihr absorbiert werden.

4. Maske nach einem oder mehreren der Ansprüche 1 bis 3, dadurch gekennzeichnet, dass das Halbleitermaterial aus einkristallinem Silicium besteht.

5. Maske nach einem oder mehreren der Ansprüche 1 bis 4, dadurch gekennzeichnet, dass die Oberflächenschicht (3) $P^+$-dotiert und das übrige Substrat N- oder P-dotiert sind, oder dass die Oberflächenschicht N-dotiert und das übrige Substrat $N^+$-dotiert sind.

6. Maske nach Anspruch 5, dadurch gekennzeichnet, dass die $P^+$-dotierte Oberflächenschicht (3) mit Bor dotiert ist.

7. Maske nach Anspruch 5 oder 6, dadurch gekennzeichnet, dass die Oberflächenschicht (3) zwischen etwa 1 und etwa 4 µm dick ist, wobei die Dicke als der Abstand von der Substratoberfläche definiert ist, bei dem die Verunreinigungskonzentration $7 \times 10^{19}$ Atome/cm³ ist.

8. Maske nach einem oder mehreren der Ansprüche 1 bis 7, dadurch gekennzeichnet, dass die Metallschicht bzw. die Metallschichten (5, 6, 16) $\geq 0{,}1$ µm über die Oberflächenschicht (3) übersteht bzw. überstehen.

9. Maske nach einem oder mehreren der Ansprüche 1 bis 8, dadurch gekennzeichnet, dass das Maskenmuster sich über mindestens eine wannenförmige Vertiefung (15) erstreckt.

10. Maske nach Anspruch 9, dadurch gekennzeichnet, dass das übrige Substrat (1) ein Netz von rippenförmigen Verstrebungen bildet, zwischen denen sich eine Vielzahl von wannenförmigen Vertiefungen (15) befindet, deren Böden in sich abgeschlossene Maskenausschnitte bilden.

11. Verfahren zum Herstellen einer Maske insbesondere nach einem oder mehreren der Ansprüche 1 bis 10, bei dem auf der Vorderseite eines Halbleiterplättchens mindestens eine metallische Schicht aufgebracht wird, in die dann das Maskenmuster unter Anwendung lithographischer Techniken geätzt wird, bei dem anschliessend die in der geätzten metallischen Schicht freiliegende Halbleiteroberfläche bis in eine festgelegte Tiefe weggeätzt wird und schliesslich von der Plättchenrückseite her wannenförmige Vertiefungen so tief in das Halbleitermaterial hineingeätzt werden, dass die in die Halbleitervorderseite geätzten Löcher auch zur Plättchenrückseite hin geöffnet sind, dadurch gekennzeichnet, dass vor dem Aufbringen der Metallschicht bzw. der Metallschichten (5, 6) das Halbleitersubstrat von der Plättchenvorderseite her bis in eine festgelegte Tiefe anders als das übrige Substrat (1) zum Erzeugen einer Oberflächenschicht (3) dotiert wird, dass nach dem Aufbringen der obersten Metallschicht (6) auf diese eine Oxidschicht (7) aufgebracht wird und in die Oxidschicht (7) Fenster (10) mit exakt senkrechten Wänden, welche das Maskenmuster wiedergeben, geätzt werden, dass dann unter Verwendung des Musters in der Oxidschicht als Maske durch die Metallschicht bzw. die Metallschichten (5, 6) hindurch und anschliessend weiter in das Halbleitermaterial tiefer, als die dotierte Oberflächenschicht (3) dick ist, hineingeätzt wird, dass anschliessend die Metallschicht bzw. die Metallschichten (5, 6) definiert unterätzt wird bzw. werden und dass nach dem vollständigen Entfernen der Oxidschicht (7) die Metallschicht (6) – wenn nötig – so weit verstärkt wird, dass zum Bestrahlen verwendete Elektronen mit festgelegter Energie vollständig in ihr absorbiert werden.

12. Verfahren nach Anspruch 11, dadurch gekennzeichnet, dass als Substrat ein dünnes, einkristallines Siliciumplättchen mit (100)-Orientierung verwendet wird.

13. Verfahren nach Anspruch 11 oder 12, dadurch gekennzeichnet, dass die Oxidschicht (7) mittels reaktiven Ionenätzens in einer $CHF_3$ oder ein $CF_4/H_2$-Gemisch enthaltenden Atmosphäre selektiv entfernt wird, und dass unter Verwendung des Lochmusters in der Oxidschicht (7) als Maske die Metallschicht bzw. die Metallschichten (5, 6) mittels Ionenätzens in einer Argonatmosphäre und die dotierte Oberflächenschicht (3) mittels reaktiven Ionenätzens in einer Argon und Chlor enthaltenden Atmosphäre selektiv entfernt werden, wobei ein Ätzratenverhältnis $SiO_2$:Si von bis zu 1:10 eingestellt wird.

14. Verfahren nach einem oder mehreren der Ansprüche 11 bis 13, dadurch gekennzeichnet, dass die Metallschicht (5) entweder mittels Plasmaätzens in einer $CF_4$ enthaltenden Atmosphäre oder mittels eines Trockenätzverfahrens unter Verwendung von Fluor ($F_2$) als Ätzmittel oder mittels einer Äthylendiamin, Brenzkatechin und Wasser enthaltenden Lösung unterätzt wird.

**Claims**

1. Mask for structurizing surface areas by means of corpuscular or X-ray beams, said mask consisting of at least one metal layer with throughgoing apertures defining the mask pattern, and of a semiconductor wafer supporting the metal layer and showing throughholes that correspond to the mask pattern and extend from the metal layer-covered surface (front) to at least one tub-shaped recess which extends from the other wafer surface (back) into the semiconductor material, characterized in that the holes (14) are provided in a surface layer (3) in the semiconductor substrate, said layer differing in its doping from the rest of the substrate (1), and that in their lateral dimensions the holes (14) are larger than the apertures (11) in the metal layer or metal layers (5, 6, 16) so that the metal layer or the metal layers (5, 6, 16), respectively, protrudes or protrude over the above surface layer (3).

2. Mask as claimed in claim 1, characterized in that the metal layer consists of a gold layer, or the metal layers of a chromium layer (5) and of gold layers (6, 16).

3. Method as claimed in claim 1 or 2, characterized in that the metal layer is so thick that electrons used for radiation are fully absorbed therein.

4. Mask as claimed in any one, or several of claims 1 to 3, characterized in that the semiconductor material consists of monocrystalline silicon.

5. Mask as claimed in any one, or several of claims 1 to 4, characterized in that the surface layer (3) is $P^+$-doped, and the remaining substrate is N- or P-doped, or that the surface layer is N-doped and the remaining substrate $N^+$-doped.

6. Mask as claimed in claim 5, characterized in that the $P^+$-doped surface layer (3) is boron-doped.

7. Mask as claimed in claim 5 or 6, characterized in that the surface layer (3) is between approximately 1 and approximately 4 µm thick, the thickness being defined as that distance from the substrate surface where the impurity concentration is $7 \times 10^{19}$ atoms/cm³.

8. Mask as claimed in any one, or several of claims 1 to 7, characterized in that the metal layer or metal layers (5, 6, 16) protrudes or protrude $\geq 0.1$ µm over the surface layer (3).

9. Mask as claimed in any one, or several of claims 1 to 8, characterized in that the mask pattern covers at least one tub-shaped recess (15).

10. Mask as claimed in claim 9, characterized in that the remaining substrate (1) forms a network of rib-shaped reinforcements between which there is a multitude of tub-shaped recesses (15) whose floors form complete mask sections.

11. Method of making a mask particularly according to any one, or several of claims 1 to 10, where on the front of a semiconductor wafer at least one metallic layer is applied into which the mask pattern is etched lithographically, where subsequently the semiconductor surface exposed in the etched metallic layer is etched off down to a predetermined depth, and where finally from the wafer back tup-shaped recesses are etched into the semiconductor material to such a depth that the holes etched into the semiconductor front also open toward the wafer back, characterized in that prior to the application of the metal layer or metal layers (5, 6) the semiconductor substrate is doped from the wafer front down to a predetermined depth, differently from the remaining substrate (1) for producing a surface layer (3), that after the application of the top metal layer (6) an oxide layer (7) is applied thereon, and that into the oxide layer (7) windows (10) with exactly vertical walls showing the mask pattern are etched, that then, using the oxide layer pattern as a mask, etching takes place through the metal layer or metal layers (5, 6) and then into the semiconductor material deeper than the thickness of the doped surface layer (3), that subsequently the metal layer or metal layers (5, 6) is or are underetched in a defined way, and that after the complete removal of the oxide layer (7) the metal layer (6) is reinforces – if necessary – to such an extent that electrons with predetermined energy used for irradiation are fully absorbed therein.

12. Method as claimed in claim 11, characterized in that as a substrate a thin monocrystalline silicon wafer with (100)-orientation is used.

13. Method as claimed in claim 11 or 12, characterized in that the oxide layer (7) is selectively removed by means of reactive ion etching in an atmosphere containing $CHF_3$ or a $CF_4/H_2$ mixture, and that using the whole pattern in the oxide layer (7) as a mask, the metal layer or metal layers (5, 6) is or are selectively removed by ion etching in an argon atmosphere, and that the doped surface layer (3) is selectively removed by means of reactive ion etching in an atmosphere containing argon and chlorine, with an etch rate ratio of $SiO_2:Si$ of up to 1:10 being set.

14. Method as claimed in any one, or several of claims 11 to 13, characterized in that the metal layer (5) is underetched either by means of plasma etching in an atmosphere containing $CF_4$, or by means of a dry etching process using fluorine ($F_2$) as an etchant, or by means of a solution containing ethylenediamine, pyrocatechol, and water.

**Revendications**

1. Masque pour réaliser des surfaces texturées au moyen de rayons corpusculaires ou de rayons X, ledit masque étant constitué d'au moins d'une couche métallique, dans laquelle sont pratiquées des ouvertures de traversée définissant la configuration de masque, et d'une microplaquette semi-conductrice portant ladite couche métallique et comportant des trous de traversée correspondant à la configuration de masque, ces trous s'étendant depuis ladite surface (avers) recouverte de ladite couche métallique jusqu'à au moins une cavité en forme de poche qui est située sur l'autre surface de la microplaquette (revers) et qui s'étend dans le matériau semi-conducteur, caractérisé en ce que lesdits trous (14) sont conçus dans une couche de surface (3) du substrat semi-conducteur, le dopage de cette couche étant d'un type différent de celui du reste du substrat (1); et en ce que les dimensions latérales desdits trous (14) sont plus grandes que celles des ouvertures (11) pratiquées dans ladite couche ou lesdites couches métalliques (5, 6, 16) de sorte que ladite couche ou lesdites couches métalliques (5, 6, 16) surplombent la couche de surface (3).

2. Masque selon la revendication 1, caractérisé en ce que ladite couche métallique est en or ou que lesdites couches métalliques sont en chrome (5) et en or (6, 16).

3. Masque selon la revendication 1 ou 2, caractérisé en ce que le revêtement métallique a une épaisseur telle qu'il absorbe complètement les électrons appliqués pour l'irradier.

4. Masque selon l'une ou plusieurs des revendications 1 à 3, caractérisé en ce que le matériau semi-conducteur est du silicium monocristallin.

5. Masque selon l'une quelconque des revendications 1 à 4, caractérisé en ce que la couche de surface (3) est dopée du type de conductivité $P^+$ et que le reste du substrat est du type de conductivité N ou P, ou en ce que la couche de surface est dopée du type de conductivité N et le reste du substrat du type de conductivité $N^+$.

6. Masque selon la revendication 5, caractérisé en ce que la couche de surface 3 du type de conductivité $P^+$ est dopée au bore.

7. Masque selon la revendication 5 ou 6, caractérisé en ce que la couche de surface (3) a une épaisseur comprise entre 1 et environ 4 µm, cette épaisseur représentant l'intervalle par rapport à la surface du substrat dans lequel la concentration d'impureté est égale à $7 \times 10^{19}$ atomes/cm³.

8. Masque selon l'une quelconque ou plusieurs des revendications 1 à 7, caractérisé en ce que ladite couche ou lesdites couches métalliques (5, 6, 16) surplombent ladite couche de surface (3) de $\geq 0,1$ µm.

9. Masque selon l'une quelconque ou plusieurs des revendications 1 à 8, caractérisé en ce que la configuration de masque recouvre au moins une cavité en forme de poche (15).

10. Masque selon la revendication 9, caractérisé en ce que le reste du substrat (1) constitue un réseau d'entretoises en forme de rainures entre lesquelles se trouvent un grand nombre de cavités (15) en forme de poche dont les fonds constituent les sections complètes du masque.

11. Procédé de fabrication d'un masque du genre de celui obtenu selon une ou plusieurs des revendications 1 à 10, où au moins une couche métallique est déposée sur l'avers d'une microplaquette semi-conductrice, sur laquelle ladite configuration de masque est gravée au moyen de techniques lithographiques, où, immédiatement après, les régions du matériau semi-conducteur exposées aux régions gravées de ladite couche métallique sont décapées jusqu'à une profondeur déterminée et où, finalement, les cavités en forme de poche ménagées sur le revers de ladite microplaquette sont décapées pour inciser dans ledit matériau semi-conducteur jusqu'à une profondeur telle que les trous gravés sur l'avers dudit matériau semi-conducteur le traversent pour atteindre le revers de ladite microplaquette, caractérisé en ce que, avant le dépôt de ladite couche ou desdites couches métalliques (5, 6), le substrat semi-conducteur est dopé dans la région comprise entre l'avers de ladite microplaquette jusqu'à une profondeur déterminée sans atteindre le reste du substrat (1) de sorte à générer une couche de surface (3), qu'après le dépôt de la couche métallique de surface (6), une couche d'oxyde (7) est déposée sur cette couche (6), et des ouvertures (10) dont les parois sont parfaitement verticales et qui reproduisent lesdites configurations de masque, sont gravées dans ladite couche d'oxyde (7), que la configuration appliquée à la couche d'oxyde est utilisée comme masque pour décaper à travers ladite couche ou lesdites couches métalliques (5, 6), ledit matériau semi-conducteur plus loin que l'épaisseur de la couche de surface (3) dopée, en ce que ladite couche ou lesdites couches métalliques (5, 6) sont immédiatement après gravées latéralement de façon définie, qu'après que ladite couche d'oxyde (7) soit complètement enlevée, la couche métallique (6) est, si cela est nécessaire renforcée de telle sorte qu'elle puisse absorber complètement les électrons d'une énergie déterminée appliqués pour l'irradier.

12. Procédé selon la revendication 11, caractérisé en ce qu'on emploie comme substrat une pastille de silicium monocristallin fine d'orientation (100).

13. Procédé selon la revendication 11 ou 12, caractérisé en ce que ladite couche d'oxyde (7) est enlevée de façon sélective au moyen d'un décapage aux ions réactifs dans une atmosphère contenant $CHF_3$ ou un mélange $CF_4/H_2$, et en ce que, d'une part, la configuration de trou appliquée sur ladite couche d'oxyde (7) est utilisée comme masque pour enlever sélectivement, ladite couche ou lesdites couches métalliques (5, 6) par décapage ionique dans une atmosphère d'argon, et que d'autre part, ladite couche de surface (3) dopée est enlevée par décapage ionique réactif, dans une atmosphère contenant de l'argon et du chlore, le rapport $SiO_2$:Si du taux de décapage atteignant 1:10.

14. Procédé selon l'une quelconque ou plusieurs des revendications 11 à 13, caractérisé en ce qu'on recourt pour décaper latéralement ladite couche métallique (5), soit à un procédé de décapage au plasma dans une atmosphère $CF_4$ soit à un procédé de décapage par voie sèche où l'on emploie du fluor ($F_2$) comme décapant, ou bien encore on recourt à une solution contenant de l'éthylènediamine, du pyrocatéchine et de l'eau.

FIG. 1

FIG. 2A

FIG. 2B

FIG. 2C

FIG. 2D

FIG. 2E

FIG. 2F

**FIG. 2G**

*P+*

*N*

11

7
6
5
3
4

**FIG. 2H**

*P+*

*N*

11
5
13

6

3

4

**FIG. 2I**

*P+*

*N*

14

6
5

3

4